# EUROPEAN PATENT APPLICATION

(11) **EP 4 657 475 A1**
(43) Date of publication of application: **03.12.2025**
(21) Application number: 25178896.4
(22) Date of filing: 26.05.2025
(51) Int. Cl.: H01G 11/28, H01G 11/36, H01M 4/04, H01M 4/133, H01M 4/1393, H01M 4/70, H10D 1/68, H01G 11/26

(54) **TECHNIQUES AND METHODS FOR FABRICATION OF THREE DIMENSIONAL NANO LAYERED COMPOSITE METAL-GRAPHENE ON INSULATOR STACK**

(30) Priority: 26.05.2024 US 202463652041 P
(71) Applicant: B2D Holding GmbH, 56070 Koblenz (DE); Grady, Eldad, 56626 Andernach (DE)
(72) Inventor: Grady, Eldad, 56626 Andernach (DE)
(74) Representative: dompatent

(57) **Abstract**

Methods and processes for fabricating three dimensional nano layered composite metal-graphene on insulator are presented in this innovation disclosure. Particularly, the invention relates to preparation of alternating metal-graphene-insulator nano layers and their composites are presented, and their applications in novel graphene devices. In this invention, a full bottom-up process is presented as a universal approach for high-efficiency and versatile novel electronic devices.

## Description

The invention provides methods and processes for fabricating three dimensional nano layered composite metal-graphene on insulator are presented in this innovation disclosure. Particularly, the invention relates to preparation of alternating metal-graphene-insulator nano layers and their composites are presented, and their applications in novel graphene devices. In this invention, a full bottom-up process is presented as a universal approach for high-efficiency and versatile novel electronic devices. Notably, the invention here relates to the fabrication of aluminum-graphene secondary batteries, supercapacitors, proton-exchange-membranes, graphene field-effect-transistors, graphene-qubits and neuromorphic computing devices, and methods of preparing stacked alternating nano-layers of graphene, metal-oxide and/or metal-fluoride in planar and 3-dimensional topologies with high aspect ratios.

### BACKGROUND OF THE INVENTION

Aluminum ion batteries are highly promising candidates as high capacity energy storage devices. As the third most abundant element in the earth's crust, Aluminum is a low-cost alternative to any existing battery chemistry. The industrial processing of Aluminum is well established, can be readily integrated in high volume manufacturing.

The working potential of current Aluminum batteries is 3.8 Volts at most, and typically lower than 2 Volts. By increasing the work potential of the battery above 5 V, the battery energy density can increase above 2000 Wh/kg.

In one embodiment of this innovation disclosure, a high energy density, high power density Alu-graphene battery fabrication method is described. Surprisingly, the proposed battery nano-layered structure can be produced by ultra thin layers, with high uniformity and homogeneity, while retaining high voltage operation, excellent heat conduction, and very low equivalent series resistivity (ESR). The battery nano-layered structure is thus highly efficient both in gravimetric and volumetric energy and power densities.

Moreover, an efficient fabrication method is presented herein, that increases the cell performances by increasing the active surface area using 3D fabrication technique

Supercapacitors offer high power densities and especially long cycle lifes. It is necessary to increase the energy density of supercapacitors in order to offer a sustainable alternative to rare earth based secondary batteries. Graphene supercapacitors offer excellent power and energy densities due the graphene's extraordinary conductivity, and charge capacity. With an active surface area of 2630 m2/g, a single graphene layer can achieve a specific capacity of 550 F/g. However, most current available graphene based supercapacitors are still not reaching their full potential, and energy densities are still lagging behind standard Li-ion batteries. The fabrication techniques previously used to stack CVD graphene have damaged the graphene sheets quality and impared the performance of the graphene-based supercapacitors.

In other embodiments of this disclosure, a graphene based solid state supercapacitor is presented, seamlessly built from nano structuring of thin layers, in order to achieve both high energy and high power density. Surprisingly, the specific capacitance of the graphene-metal composite is increasing with the number of graphene layers, up to 6 layers, due to the graphene's quantum capacitance contribution.

In other embodiments in this disclosure, a graphene field-effect-transistor is presented, seamlessly built from nano structuring of thin layers, in order to achieve high efficiency, high frequency and low power transistor.

In this disclosure, the metal-graphene-insulator-solid electrolyte composite stack is designed to relay on abundant material in the earth's crust, and is environment-friendly device and safe, that can be readily recycled.

### DETAILED DESCRIPTION OF EMBODIMENTS

According to an embodiment of the present invention, parts of a nano-layered solid state battery are presented. The nano layers include graphene, specifically CVD grown continuous films of graphene, or a plurality of graphene layers. The nano layers include a solid state electrolyte component, and an anode comprised of a metal element or its compounds.

In all of the enumerated embodiments described herein and as will be understood by one skilled in the art with reference to this disclosure, the graphene layer may be single layer of graphene, few layer graphene, or multilayered graphene.

Particularly, it is an object of the invention to provide energy storage devices based on high quality graphene. High quality graphene films, which are highly continuous, homogeneous and uniform and have a low number of defects are to be provided.

The inventive process may consist of the aforementioned steps. The graphene film may consist of one or more graphene layers. The substrate may be partially or fully coated with the catalyst layer. The graphene film may be grown on a part of the catalyst coating or on the entire catalyst coating.

The term "conformally" or "conformal growth" as used herein denotes that a layer is congruent with the underlying layer and that the underlying layer is covered by the conformal layer. Particularly, the conformal layer is continuous, homogeneous and has the same topology as the underlying layer. Preferably, the conformal layer is uniform in its thickness over the conformally coated area and has a variance of thickness of less than 20%, more preferably less than 10%. Conformal coating may refer to a full coating or a partial coating.

The substrate may have any suitable form and may be made from any suitable material. The invention is not limited to a particular form or a particular material of the substrate.

The substrate may be rigid or flexible material. Preferably, the substrate comprises or consists of a metallic or ceramic material and/or their mixtures. Alternatively, the substrate may comprise or consist of an inner material and an outer material or surface material of a metallic or ceramic material and/or their mixtures. Particularly, the substrate may comprise or consist of Al, Ti, V, Zr, Mo, W, Ta, Nb, Cr, Hf, their alloys and mixtures, their oxides, nitrides and/or carbide compounds. The aforementioned materials may also constitute the outer shell of the substrate.

In some embodiments, the substrate is an insulator layer, preferably topological insulator, comprises or consists of dielectric thin film. Particularly, the substrate may comprise or consist of h-BN, Si, Bi, Te, Se, Sb, their mixtures, their oxides, nitrides and/or carbide compounds. The aforementioned materials may also constitute the outer shell of the substrate.

Graphene layers may be grown on the substrate by means of atomic or molecular layer deposition (ALD/MLD) assisted processes. Initially, a catalytic thin film is deposited on the surface. The catalytic film may be a carbon film or a carbon-rich film.

The catalytic carbon thin film may be transformed to one or more graphene layers by supplying the film surface with energy. The energy source for forming the sp2 hybridized carbon bonds characteristic of graphene may be thermal, plasma ions, plasma radicals, photons, or a mixture thereof.

Graphene may also be obtained from a catalytic thin film by carburization of the film, for example by thermal treatment at temperatures between 600 to 850 °C, and a carbon feedstock, especially methane or ethanol.

Subsequently, graphene layers may be grown on the surface of the carborized film by a second thermal treatment step in temperature ranging from 800 to 1300 °C. The second thermal treatment can be performed with or without a carbon rich feedstock.

The graphene film obtained may comprise or consist of one or more graphene layers. Preferably, the graphene film is a multilayer graphene film. The graphene film has the same aspect ratio three-dimensional topology as the substrate. The graphene film is especially continuous and homogeneous and is of high quality.

The quality of the graphene film obtained may be characterized by Raman spectroscopy and X-ray photoelectron spectroscopy. The inventive method may yield a three-dimensional high quality graphene film having a narrow Raman 2D/G peak ratio density (less than 20·10-2), a narrow Raman defect (D/G peak ratio) density distribution (variance less than 200·10-4), preferably a low D/G peak mean ratio (less than 0.5), and high content of sp2 hybridized carbon (more than 90%) in its top layers and surface.

The inventive graphene energy storage device may consist of one or more graphene layers. The inventive graphene energy storage device has a high quality graphene film, i.e., a high continuity and high homogeneity. Particularly, the amount of sp2 hybridized carbon atom in its top layer and surface may be more than 90%, when measured with X-ray photoelectron spectroscopy. The inventive graphene energy storage device may have all of the aforementioned qualitative properties of the graphene films, obtainable by the inventive method.

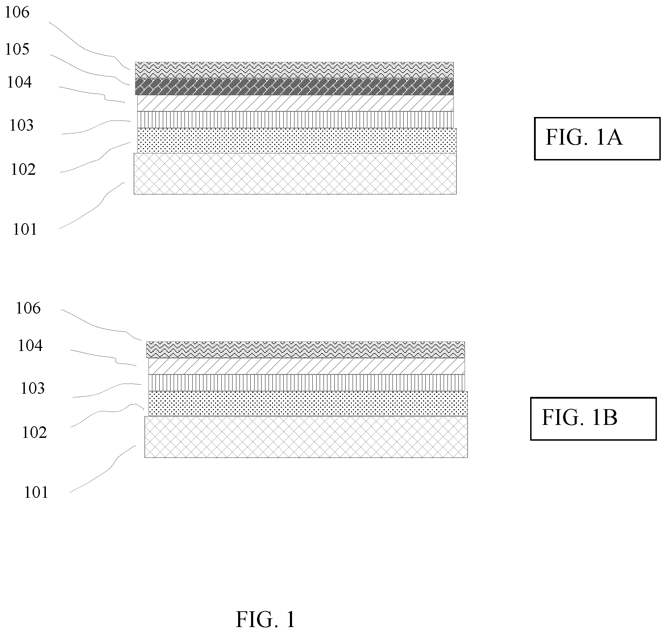

As shown in figure 1, a heterostructure of nano-layers on top of a bottom support layer 101 is fabricated. The heterostructure is comprised of a metal-graphene layer 102, coated by thin metal oxide layer, coated by a metal-fluoride layer, coated by a metallic layer.
The graphene is single layer or a plurality of graphene layers, preferably more than 2 layers, preferably lower than 50 layers, most preferably 5 or 6 layers.
The metallic layer can be metal nitride, metal carbide compound, or a metal element. The graphene may be grown on the metallic structure as described for example in {E. Grady (2020), WO 2022/101210}. The invention is not limited to the specified metallic layer elements, and it is understood that there may be various precursor metal-organic molecules suitable for the deposition of the metal structure.

In some embodiments, the graphene may be grown directly on the support layer, without the intermediate metallic layer.

The graphene top layer or layers 103 may have been transformed, such that they form sp3 bonds. The sp2 to sp3 transition in the graphene layers may be photoinduced by a laser, more preferably An ultrafast laser pulse with a photon energy of 1.55 eV with a laser fluence of F = 0.905 mJ cm-2 for a period of 500 fs. Alternatively, by plasma, for example SF6 plasma, H2 Plasma, or O2 Plasma, or any plasma containing O, H or F.
The top layer or layers may be oxidised or hydrogenised, or fluorinated, so that they bond with O, H or F. The process of bonding can be performed by plasma treatment, thermal treatment, chemical treatment.
The top graphene layer may be coated by a metal oxide layer 104, and may comprise or consist of Al, Ti, V, Zr, Mo, W, Ta, Nb, Cr, Hf, their alloys and mixtures, their oxides, nitrides and/or carbide compounds.
The deposition may be performed by CVD, PVD, preferably by ALD.
The thin metal oxide layer may be 5 nm, or 10 nm and up to 40 nm.

The stack may be coated by another layer 105, a solid electrolyte, such as Na based electrolytes, Cl based electrolytes, such as NaCl, Kcl, Al2Cl7- and AlCl4-, or LLZTO, or LiPF6 , LiPON, LiF, (MeO)3PO, Ta(OEt)5, Nb(OEt)5, Si(OC2H5)4, H2NP(O)(OC2H5)2, P(NMe2)3, Al2(NMe2)6, LaFAMD, Zr(NMe2)4, TiF4, and [(CH3)2CHO]3B, beta-alumina. Preferably metal-fluoride layer, preferably, most preferably AIF3, or any other conceiveable variations and combinations thereof.
The thickness of the solid electrolyte layers 105 is 1-50 nm, preferably 1-20 nm, most preferably 1-10 nm.
The structure may then be coated by a conductive metallic layer 106. The conductive metal layer may be Li, Ti, Ta, Mo, Cr, W, Ni, Cu,Pt, Pd or any mixture of those elements, preferably Al.
Layer 106 thickness may be 10 nm, or 20 nm, and preferably lower than 100 micrometers. Most preferably, lower then 100 nm.
The deposition may be performed by CVD, PVD, preferably by ALD.

This Process may repeat itself for an arbitrary number of times, forming a seamless stack of metal-graphene, metal-fluride, metal-oxide stacks.
The structure stack may then be exposed to etching chemical gas vapour or solution to selectively remove the metal layer 102 underneath the graphene layers, so that only graphene is left in layer 102.

In some embodiments, the transformation of the graphene layers from hybridised sp2 bond to sp3 may be performed selectively, for example by limited laser exposure along a defined path.

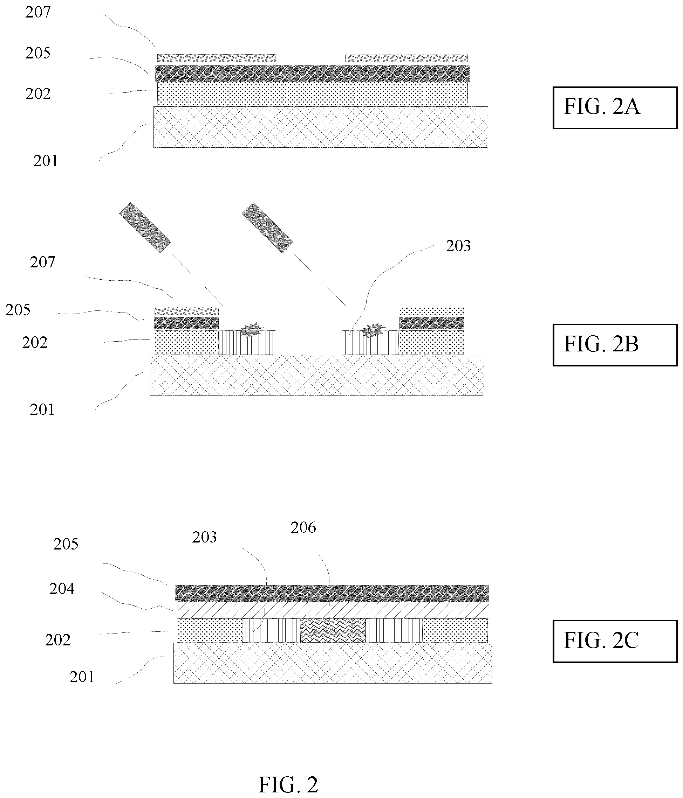

The graphene layer or layers may be first coated by a polymer layer 207 and photosensitive material, as shown in figure 2A. A defined path in layer 207 may be then formed by a photolithography process on the photosensitive material, to expose the polymer at the defined sites. The polymer may then be removed by oxygen plasma. Then, the photosensitive material is removed.

In some embodiments the underlying graphene 202 may be partially exposed and etched away, by plasma etching or laser ablation. A larger opening in layer 207 may then be made, and the exposed graphene layer or layers may be treated with ultra fast laser to induce sp2 to sp3 transition of the graphene layers 203 at the exposed locations, as shown in figure 2B.
The structure may then be selectively coated by a metallic layer 206. The metallic layer may be as described for layer 106, a metal element, or any of its compounds. The deposition may be performed by CVD, PVD, preferably by ALD. The residue polymer may be removed.
Then, a solid electrolyte layer 204 is deposited, such as Na based electrolytes, or Cl based electrolytes , such as NaCl, Kcl, Al2Cl7- and AlCl4-, or LLZTO, or LiPF6 , LiPON, LiF, (MeO)3PO, Ta(OEt)5, Nb(OEt)5, Si(OC2H5)4, H2NP(O)(OC2H5)2, P(NMe2)3, Al2(NMe2)6, LaFAMD, Zr(NMe2)4, TiF4, and [(CH3)2CHO]3B, beta-alumina, preferably metal-fluoride layer, prefereably TiF4, LiF, most preferably AIF3, or any other conceivable variations. The coating may be performed by CVD, PVD, or ALD, preferably ALD using SF6 plasma.
The stack can then be coated by insulating material layer 205, such as Al2O3, TiO2, HfO, or h-BN.

In some embodiments the underlying graphene 302 may be partially exposed and treated to alter its chemical and/or physical properties. A larger opening in layer 307 may then be made, and the exposed graphene layer or layers may be treated with ultra fast laser to induce sp2 to sp3 transition of the graphene layers 303 at the exposed locations, as shown in figure 2B.

Alternatively, the underlying graphene layer 304 may be partially exposed to plasma for a period of 5-60 seconds, preferably 10-30 seconds, for 1-10 cycles, preferably 1-3 cycles. The gas co-reactant in the plasma may be N2, O2, H2, NH3, CH4, CF4, SF6, preferablly H2, preferablly N2.

The structure may then be selectively coated by a metallic layer 306. The metallic layer may be as described for layer 106, a metal element, or any of its compounds. The deposition may be performed by CVD, PVD, preferably by ALD. The residue polymer may be removed.

The structure may be coated with a solid electrolyte layer 304 is deposited, such as Na based electrolytes, or Cl based electrolytes, such as NaCl, Kcl, Al2Cl7- and AlCl4-, or LLZTO, or LiPF6 , LiPON, LiF, (MeO)3PO, Ta(OEt)5, Nb(OEt)5, Si(OC2H5)4, H2NP(O)(OC2H5)2, P(NMe2)3, Al2(NMe2)6, LaFAMD, Zr(NMe2)4, TiF4, and [(CH3)2CHO]3B, beta-alumina, preferably metal-fluoride layer, prefereably TiF4, LiF, most preferably AIF3, or any other conceiveable variations. The coating may be performed by CVD, PVD, or ALD, preferably ALD using SF6 plasma.

The stack can then be coated by insulating material layer 305, such as Al2O3, TiO2, HfO, SiO2 or h-BN. The coating may be performed by CVD, PVD, Ion beam induced deposition (IBAD), or ALD, preferably ALD.

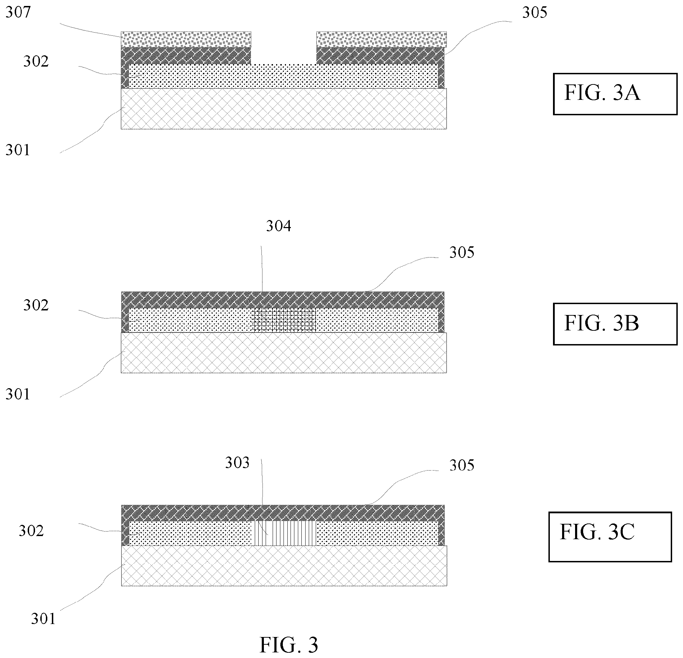

In other embodiments, the graphene layers are coated with a thin polymer coating. Then, a path may be defined by applying focused heat on defined locations, for example by thermal scanning probe lithography, to evaporate the polymer below probe tip, such that the underlying graphene is exposed. The exposed underlying graphene layer 502 may then be etched by oxygen plasma, as shown in figure 3. The structure may then be selectively coated by a metallic layer 506. The metallic layer 506 may be as described for layer 106, a metal element, or any of its compounds. The deposition may be performed by CVD, PVD, preferably by ALD. The residue polymer may be removed.
A layer 504 of solid electrolyte is deposited. The solid electrolyte may be as described for layer 105. Preferably the solid electrolyte is a metal-fluoride layer, preferably TiF4, LiF, most preferably AIF3, or any other conceivable variations.
The layer 504 is then coated with an insulating layer 505. Layer 505 can be metal oxide, such as any of the following elements and may comprise or consist of Al, Ti, V, Zr, Mo, W, Ta, Nb, Cr, Hf, their alloys and mixtures, their oxides, nitrides and/or carbide compounds. Preferably Al2O3, TiO2, VOx and their combinations.
The thin metal oxide layer may be 5 nm, or 10 nm and up to 40 nm.

In some embodiments, an intermediate h-BN layer is grown on top of the graphene layers or below.
In some embodiments, the process shown in figure 1 is repeated, such that multiple metal-graphene-oxide-fluoride-metal-insulation layers are seamlessly grown on top of each other.
In some embodiments, parts of the substrate are selectively covered, so that after the growth process, the underlying layer is exposed. The selective cover material can be a polymer, a fiber, or any organic material.

In some embodiments, the selective cover is shifted in every new structure stack, so that every second metal-graphene stack is exposed underneath the holes.

In some embodiments the selective cover is shifted such that every layer for n number of shifts is separately exposed.

In some embodiments, the selective layer exposure is performed by laser ablation.

In some embodiments, the selective layer exposure is performed by means photolithography of chemical sensitive material (resist) and chemical etching of the exposed areas.

In some embodiments, the selective layer exposure is performed by means of atomic layer etching (ALE).

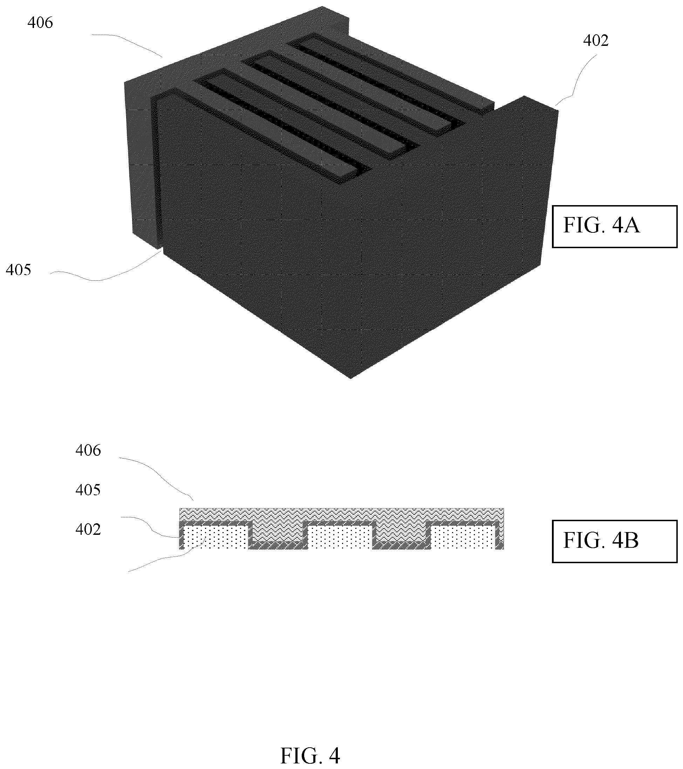

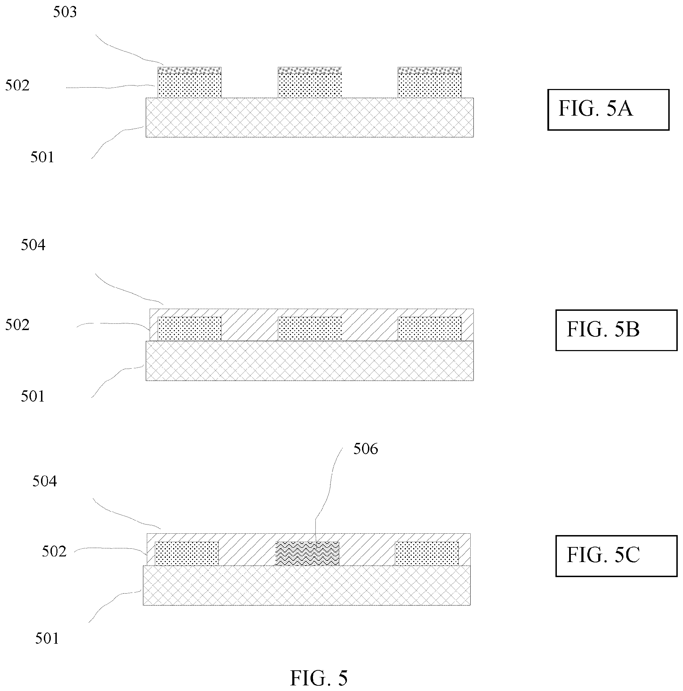

In some embodiments, a 3D porous printed structure is deposited on a light sensitive thin film. The structure can be selectively deposited by the printer, for example a 3D structure is printed on the substrate using a Original Prusa i3 MK3S+ 3D printer. The 3D printer fillament used is PLA. Alternatively, the 3D porous structure can be patterned by laser ablation and the excess material removed, as shown in figure 4.
A metal layer 402 may be deposited on top of the 3D porous printed structure and the light sensitive material.
The light sensitive material is then removed by chemical means, for example using an IPA solvent, Acetone or PGMA.
The metal coated 3D porous printed structure may be processed in a CVD system under laminar flow. The structure may then be coated by a solid state electrolyte layer 405, as described in layer 105. Layer 405 of the 3D structure may be coated by a metallic layer 406, as described for layer 106.

In some embodiments, a 3D structure is created by patterning a 3D porous printed structure with a thin polymer layer. Preferably parylene, more preferably high-temperature parylene such as Parylene F, most preferably Parylene AF-4. The parylene layer can be released from the 3D structure by chemical means, for example using an IPA solvent, Acetone or PGMA. The parylene layer is then transferred onto a carrier substrate and adhesed by applying pressure and thermal heating.

In some embodiments, the 3D porous structure has high aspect ratio (HAR), preferably 10, more preferably 100, most preferably above 1000. The 3D HAR structure may be nanowires, cellulose fibers, nanotubes, or DNA strings.

In some embodiments, the nano layers are deposited directly on top each lower layer, with high homogeneity and uniformity.

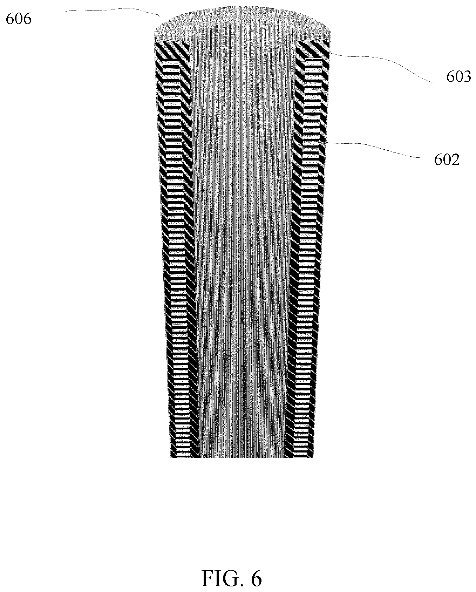

In some embodiments, the nano layers are deposited directly on top each lower layer, on a high-aspect ratio 3 dimensional structure, as shown in figure 6, with high homogeneity, uniformity and conformality. Layer 602 comprises of metal-graphene structure is deposited and grown by a CVD process, directly on the nanotube frame. Layer 603 can be conformally and uniformly deposited so that it may coat the exposed surface of layer 602. Layer 603 may be metal-oxide, metal-fluoride, beta-alumina or any solid state electrolyte as described for layer 105. Layer 603 is preferably between 5 - 60 nm thick. More preferably between 5-40 nm thick. Layer 606 may be deposited on layer 603 in a similar manner, to create a seamless nano layered coating of a metallic layer. The metal may be W, Cu, Ni,Pt, Pd, Mo, Cr, Ti, Ta, Al, or any of their compounds. More preferably Al, as described for layer 106.

The stack of metal-graphene-graphane-graphene oxide-metal fluoride can be stacked on other similar stacks.

The stack is then coated by an insulation layer, such as h-BN, Al2O3, TiO2, HfO.
The stack can then be patterned with a metallic layer to make contacts.
The patterned metallic layer may be formed by a lift-off process via photolithography.
A metal layer may be deposited on the exposed surface by sputtering, evaporation, or ALD.

In some embodiments, patterning the metallic layer is performed by electron beam deposition.

In some embodiments, the patterned metallic layer is deposited via area selective ALD (AS-ALD). The AS-ALD may be performed under vacuum conditions, more preferably under atmospheric ambient conditions.

In some embodiments, the nano layers heterostructure is present along a defined path. The path can be defined by photolithography, and chemical or plasma etching.

In other embodiments, the path can be defined by laser ablation and removal of excess material.

In some embodiments the deposited layers are defined by area selective atomic layer deposition, preferably, spatial area selective atomic layer deposition.

In some embodiments, the defined path is defined by atomic layer etching, preferably, spatial atomic layer etching. The ALD may be performed under vacuum conditions, more preferably under atmospheric ambient conditions.

The layered structure can be produced on a wafer, or on a thin film.
Preferably, the layers are produced in a batch production.
Most preferably, the layers are produced in a roll-to-roll manner, via continuous ALD and CVD deposition in a laminar flow.
The ALD may be spatially divided for the ALD precursor and co-reactant deposition, such that continuous film deposition at high deposition rate is possible.
The ALD process may be performed as Plasma Enhanced ALD for low temperature deposition, preferably below 300 degree celsius, more preferably below 150 degree celsius. The ALD may be performed as a Thermal ALD process for high temperature deposition, preferably higher than 300 degree celsius, most preferably higher than 400 degree celsius.

The graphene growth is performed by CVD, and can be performed on a wafer or on a foil, in a hot walled furnace, or on a roll to roll system.
The CVD deposition is performed at high temperature under laminar flow conditions of hydrocarbon molecules, as described in the invention disclosure {E. Grady (2020), WO 2022/101210, patent pending}. The continuous CVD deposition allows for rapid thermal heating of the substrate, and fast cooling, as a function of the location of the film.
Finally, the nano-layers heterostructure may be coated with sealing materials, such as polymers, preferably parylene.

The sealing coating may be perforated at selected locations, by means of plasma or chemical etching.
The exposed locations may be coated with a conductive material, such as metal.

The coating my be performed by evaporation, sputtering, ALD, or conductive ink printing.

The conductive material may be Au, Ag, Pd, Pt, Mo, W, Cr, Ti, Ta or any compound thereof.

The nano-layered heterostrucutre can be stacked on top of each other, such that the exposed conductive layers are aligned vertically.

The stacked structures may be bonded by applying mechanical pressure, and or thermal heating, to strengthen the contact between each structure.

The bonded structures may then be sealed under vacuum conditions, for example in a pouch cell.

In an alternative embodiment, the object of the invention is solved by the use of the inventive three-dimensional graphene film in a graphene field effect transistor, in a neuromorphic processor device, or in interconnect vias.

As transistor nodes are being scaled down to improve CPU performance, power consumption and delay increases due to increased current density in Cu interconnects (IC). The smaller dimension IC have less metal volume, and resistivity increases exponentially when transitioning from 10 nm to 5 nm transistor nodes.

The transistor's delay, determined by the R·C product is expected to increase by 40% when nodes decrease from 10 to 5 nm. Electromigration of Cu atoms is also expected to increase due to the high current density, resulting in voids in the Cu film.

Other material considered as substitute metal for IC, such as Co or Ru have lower resistivity than Cu only at dimensions smaller than 10 nm. Thus, Cu is still the main metallic film used for IC. Moreover, due to Cu diffusion in the interlayer dielectrics (ILD), a diffusion barrier layer is needed, which reduces the volume of the conductive metal.

Moreover, graphene has among the highest in-plane thermal conductivity of any known material with over 3000 W·M-1·K-1, which allows for faster heat evacuation and improved transistor performance.

Previously, graphene has been suggested as a replacement for IC, but thus far no successful implementation of graphene could be performed. It is expected to outperform current metal VIAs due to Lower R·C: high mobility, low per-unit-length resistance, lower capacitance, high current carrying capacity.

Typically, CVD graphene is grown on Cu, and as a single layer graphene (SLG) has defects than degrade its electrical conductivity. Multilayer graphene (MLG) grown on Ni substrate needs to be transferred onto the target substrate, which is detrimental to its structural integrity and performance. Furthermore, growth is done on planar substrates, which limits MLG integration to various VIA topologies.

By employing the inventive method described above, a bottom-up fabrication of graphene field-effect-transistor with ICs is presented. The method provides nm thick layers of alternating film of graphene layers of high purity and homogeneity, and insulators in a transfer-free technique.

The method includes a deposition of conductive catalytic film on insulator. Following the film deposition, a CVD growth of graphene is performed, which grows a uniform graphene plurality film on top of the conductive catalytic substrate. The conductive catalytic film may be removed from the stack and the stack encapsulated with a top layer. The deposition and growth sequence can be iterated multiple times to increase the volume of graphene-metal-insulator layers, to allow a high configuration degree of the device.
This growth allows for a scalable uniform method to fabricate graphene FET for the next generation transistors.

In some embodiments, the method includes a deposition of a carbon-rich thin catalytic film on insulator. The thin carbon film forms a graphene layer or layers by plasma-assisted ALD, or photo-assisted ALD or a mixture thereof. The deposition and growth sequence can be iterated multiple times to allow a high configuration degree of the device.

The G-FET can be fitted with IC VIAs in varying diameters to connect to the bottom stacks of the transistor to the upper layers. Thus, a modular implementation of G-FET and VIAs fabrication can be achieved for the entire stack. The conductive catalytic film is suitable for use as IC layer and the insulator encapsulation improves the device electrical performance.

In accordance with the statute, the description of the invention is in language which is more or less specific to structural or method features. The invention is not limited to the specific features shown above or described in items hereinafter, since the means described herein include preferred ways to implement the invention.
Item 1. A process for the preparation of three-dimensional graphene insulator metal composite structure comprising the steps of
   a) providing a substrate having a three-dimensional surface topology, wherein said three-dimensional topology comprises a plurality of protruding structures and a plurality of cavities between two or more protruding structures;
   b) coating at least a portion of the substrate conformally with a catalyst layer; and
   c) conformally growing a graphene film on at least a portion of the catalyst, wherein the graphene film comprises one or more graphene layers; and
   d) conformally coating at least part of the graphene film with metal-oxide and/or h-BN layer; and
   e) conformally coating at least part of the metal-oxide layer with metal-fluoride layer; and
   f) conformally coating at least part of the metal-fluoride layer with a metal and/or metal-oxide layer; and
   g) repeated stacking of a stack of said layers according to claims a) to f) on top of a similar stack; and
   h) sealing the stacks, especially under vacuum conditions.
Item 2. The process according to item 1, wherein the plurality of protruding structures are selected from nanotubes, nanopillars, nanowires, fibers and/or cellulose.
Item 3. The process according to item 2, wherein a ratio between a surface area of the protruding structures and corresponding cavities and a base area on the substrate covered by said protruding structures and cavities is in the range of from 5 to 100,000, especially 100 to 100,000.
Item 4. The process according to one or more of items 1 to 3, wherein the substrate having a three-dimensional topology covers at least part of the substrate.
Item 5. The process according to one or more of items 1 to 4, wherein the catalyst layer comprises elementary or compound transition metals or metals deposited in a conformal way.
Item 6. The process according to item 5, wherein the catalyst layer comprises carbides and/or nitrides of Mo, W, Ta, Ti, Nb, Zr, Va, La, Yt, Cr, Hf, Ni, Cu or Pt.
Item 7. The process according to one or more of items 1 to 6, wherein conformally coating of the substrate with a catalyst layer comprises thin film deposition techniques.
Item 8. The process according to claim 7, wherein said thin film deposition techniques comprise atomic layer deposition (ALD), especially plasma enhanced atomic layer deposition (PEALD), especially high-temperature ALD (HTALD), physical vapour deposition (PVD) or chemical vapour deposition (CVD).
Item 9. The process according to item 8, wherein coating of the substrate comprises plasma enhanced atomic layer deposition comprising at least one precursor dose step, a first purge step, a plasma exposure step and a second purge step, wherein the catalyst layer comprises a carbide of Mo, W, Ta, Ti, Nb, Zr, V, La, Yt, Cr, Hf, Ni, Cu or Pt.
Item 10. The process according to item 8, wherein coating of the substrate comprises plasma enhanced atomic layer deposition comprising at least one precursor dose step, a first purge step, a plasma exposure step and a second purge step, wherein the catalyst layer comprises a benzene compound or generally compounds comprising methine groups, without limitation. Preferably, methane, ethanol, ethane, ethene, ethyne, propane, propene, propadiene, propyne, butane,butene, butadiene, butariene, and/or butyne.
Item 11. The process according to item 8, wherein coating of the substrate comprises high temperature atomic layer deposition comprising at least one precursor dose step, a first purge step, a co-reactant gas step and a second purge step, wherein the catalyst layer comprises a carbide of Mo, W, Ta, Ti, Nb, Zr, V, La, Yt, Cr, Hf, Ni, Cu or Pt.
Item 12. The process according to one or more of items 1 to 11, wherein conformally growing a graphene film on the catalyst coating comprises plasma treatment at temperature lower than 600 °C. Preferably, lower than 500°C, especially lower than 400 °C.
Item 13. The process according to one or more of items 1 to 12, wherein conformally growing a graphene film on the catalyst coating comprises thermal treatment at a temperature between 600°C and 850 °C with a carbon feedstock and subsequently growing graphene layers by a second thermal treatment at a temperature between 800 and 1300 °C.
Item 14. The process according to one or more of items 1-13, wherein conformally coating of the graphene film with a thin film. The film may be an insulator and/or a metal-compound layer comprises thin film deposition techniques.
Item 15. The process according to item 14, wherein coating of the substrate comprises plasma enhanced atomic layer deposition comprising at least one precursor dose step, a first purge step, a plasma exposure step and a second purge step, wherein the insulator comprises h-BN and/or the metal-compound layer comprises of Al, Mo, W, Ta, Ti, Nb, Zr, V, La, Yt, Cr, Hf, Ni, Cu or P and their oxides, nitrides, and/or dihalogonides.
Item 16. The process according to one or more of items 1 to 15, wherein conformally coating of the thin film insulator and/or the metal-oxide with a solid state electrolyte layer comprises thin film deposition techniques.
Item 17. The process according to item 16, wherein said thin film deposition techniques comprise atomic layer deposition (ALD), especially plasma enhanced atomic layer deposition (PEALD), physical vapour deposition (PVD) or chemical vapour deposition (CVD).
Item 18. The process according to item 17, wherein coating of the substrate comprises plasma enhanced atomic layer deposition comprising at least one precursor dose step, a first purge step, a plasma exposure step and a second purge step, wherein the solid state electrolyte layer comprises of a fluoride of Al, Mo, W, Ta, Ti, Nb, Zr, V, La, Yt, Cr, Hf, or NaCl, Kcl, Al2Cl7- and AlCl4-, or LLZTO, or LiPF6 , LiPON, LiF, (MeO)3PO, Ta(OEt)5, Nb(OEt)5, Si(OC2H5)4, H2NP(O)(OC2H5)2, P(NMe2)3, Al2(NMe2)6, LaFAMD, Zr(NMe2)4, TiF4, and [(CH3)2CHO]3B, beta-alumina, preferably metal-fluoride layer, prefereably TiF4, LiF, most preferably AlF3, or any other conceiveable variations.
Item 19. The process according to one or more of items 1 to 18, wherein conformally coating at least a portion of the metal-fluoride layer conformally with a metal and/or metal-oxide layer comprises thin film deposition techniques.
Item 20. The process according to item 19, wherein said thin film deposition techniques comprise atomic layer deposition (ALD), especially plasma enhanced atomic layer deposition (PEALD), physical vapour deposition (PVD), chemical vapour deposition (CVD), Electron beam induced deposition (EBID) or thin film evaporation techniques.
Item 21. The process according to item 20 wherein coating of the substrate comprises plasma enhanced atomic layer deposition comprising at least one precursor dose step, a first purge step, a plasma exposure step and a second purge step, wherein the metallic layer comprises an elementary or compound metals of Al, Mo, W, Ta, Ti, Nb, Zr, V, La, Yt, Cr, Hf, Ni, Cu, Ag, Au, Pd or Pt deposited in a conformal way.
Item 22. A three-dimensional homogenous graphene film obtainable by the process according to one or more of items 1 to 13.
Item 23. An electrode comprising the three-dimensional homogenous graphene film according to item 22 conformally on a three-dimensional substrate.
Item 24. A solid state electrolyte, according to item 18.
Item 25. A electrode metallic layer, according to item 21.
Item 26. An energy storage device comprising the anode, electrolyte, cathode a according to items 23-25.
Item 27. Stacking of energy storage devices, according to item 26.
Item 28. Sealing, for example in a pouch cell, of said energy storage device, according to item 27.
Item 29. A graphene-field-effect-transistor, according to items 23-25.
Item 30. Use of the three-dimensional graphene-metal composite device, according to items 28-29, in an Aluminum-graphene battery, in a supercapacitor, in a proton exchange membrane, in a quantum dot device, in a neuromorphic memristive synapse, in graphene-field effect transistor or as an interconnect.
It is preferred that the graphene-battery power density is higher than 1 kW, preferably 5 kW, most preferably 10 kW. The battery's energy density is higher than batteries (up to 265 Wh/kg), preferably higher than 1000 Wh/kg, most preferably higher than 2000 Wh/kg.

The invention is further described by the following examples, which are not to be construed as limiting the invention.

### BACKGROUND OF THE INVENTION

### Example 1:

A substrate comprises of a thin SiN film is used as a support carrier for the layered stack.

In a first step, the three-dimensional substrate is conformally coated with an intermediate layer of SiO2. The SiO2 film is deposited by thermal atomic layer deposition with AP-LTO^{®}330 as Si precursor. The co-reactant half cycles are carried out with O3 as the oxygen source.

Deposition temperature was set to 300 °C. Film thickness of 10 nm of SiO2 is deposited by the thermal ALD process.

In a second step, a thin metallic film is deposited via atomic layer deposition. The metallic film is a catalyst layer of molybdenum carbide by means of plasma enhanced atomic layer deposition (PEALD). bis(tert-butylimido)-bis(dimethylamido)-molybdenum, Mo(tBuN)2(NMe2)2 (98%, Strem Chemicals), was employed as precursor. The precursor was bubbled by an argon flow of 50 sccm during the precursor dose step to the reaction chamber. During the plasma exposure step, a co-reactant H2/Ar is flowed to the reaction chamber, with a 4:1 ratio.

After the deposition of the catalyst layer, high quality graphene film was grown conformally on the catalyst layer. The catalyst film was saturated with carbon by annealing for 2 hours at 800 °C under low pressure of 4 mbar with CH4 as carbon feedstoock. Subsequently, graphene films were grown under similar conditions at 1100 °C for 10 minutes.

In a third step, The top graphene films are exposed to hydrogen plasma for 30 seconds. After the plasma exposure, a thermal ALD process to deposit Al2O3 films was performed. A layer of 10-40 nm Al2O3 film was deposited, preferably 10-20 nm.

In a fourth step, AIF3 was deposited by Plasma Enhanced ALD (PEALD), using Al(CH3)3 (TMA) precursor and SF6 plasma as a co-reactant step. Details of the deposition process and conditions are described by (Vos et. al., 2021). The Al-fluoride film thickness is 10 nm.

In a fifth step Al film was deposited on top of the underlying AIF3 film. The deposition was performed by PEALD using TMA as a precursor and H2 plasma as a co-reactant. The Al film thickness is 100 nm.

### Example 2:

A substrate comprises of a SiN film is used as a support carrier for the layered stack.

In a second step, the three-dimensional substrate is conformally coated with an intermediate layer of SiO2. The SiO2 film is deposited by thermal atomic layer deposition with AP-LTO^{®}330 as Si precursor. The co-reactant half cycles are carried out with O3 as the oxygen source.

Deposition temperature was set to 300 °C. Film thickness of 10 nm of SiO2 is deposited by the thermal ALD process.

In a third step, a thin metallic film is deposited via atomic layer deposition. The metallic film is a catalyst layer of molybdenum carbide by means of plasma enhanced atomic layer deposition (PEALD). bis(tert-butylimido)-bis(dimethylamido)-molybdenum, Mo(tBuN)2(NMe2)2 (98%, Strem Chemicals), was employed as precursor. The precursor was bubbled by an argon flow of 50 sccm during the precursor dose step to the reaction chamber. During the plasma exposure step, a co-reactant H2/Ar is flowed to the reaction chamber, with a 4:1 ratio.

After the deposition of the catalyst layer, high quality graphene film was grown conformally on the catalyst layer. The catalyst film was saturated with carbon by annealing for 2 hours at 800 °C under low pressure of 4 mbar with CH4 as carbon feedstoock. Subsequently, graphene films were grown under similar conditions at 1100 °C for 10 minutes.

In a fourth step, the top graphene films are exposed to hydrogen plasma for 30 seconds. After the plasma exposure, a thermal ALD process to deposit Al2O3 films was performed. A layer of 10-40 nm Al2O3 film was deposited, preferably 10-20 nm.

In a fifth step, AIF3 was deposited by Plasma Enhanced ALD (PEALD), using Al(CH3)3 (TMA) precursor and SF6 plasma as a co-reactant step. Details of the deposition process and conditions are described by (Vos et. al., 2021).

In a sixth step Al film was deposited on top of the underlying AIF3 film. The deposition was performed by PVD.

### Example 3:

A substrate comprises of a SiN film is used as a support carrier for the layered stack.

In a second step, the substrate is conformally coated with an intermediate layer of SiO2. The SiO2 film is deposited by thermal atomic layer deposition with AP-LTO^{®}330 as Si precursor. The co-reactant half cycles are carried out with O3 as the oxygen source.

Deposition temperature was set to 300 °C. Film thickness of 10 nm of SiO2 is deposited by the thermal ALD process.

In a third step, a thin metallic film is deposited via atomic layer deposition. The metallic film is a catalyst layer of molybdenum carbide by means of plasma enhanced atomic layer deposition (PEALD). bis(tert-butylimido)-bis(dimethylamido)-molybdenum, Mo(tBuN)2(NMe2)2 (98%, Strem Chemicals), was employed as precursor. The precursor was bubbled by an argon flow of 50 sccm during the precursor dose step to the reaction chamber. During the plasma exposure step, a co-reactant H2/Ar is flowed to the reaction chamber, with a 4:1 ratio.

After the deposition of the catalyst layer, high quality graphene film was grown conformally on the catalyst layer. The catalyst film was saturated with carbon by annealing for 2 hours at 800 °C under low pressure of 4 mbar with CH4 as carbon feedstoock. Subsequently, graphene films were grown under similar conditions at 1100 °C for 10 minutes.

In a fourth step, The top graphene films are exposed to oxygen plasma to form Graphene-oxide films. The plasma exposure step is performed for 6 seconds and after each exposure step the chamber is purged with Ar gas flow. The oxygen plasma exposure is performed for 3 cycles.

After the plasma exposure, a plasma ALD process to deposit Al2O3 films was performed. A layer of 10-40 nm Al2O3 film was deposited, preferably 10-20 nm.

In a fifth step, AIF3 was deposited by Plasma Enhanced ALD (PEALD), using Al(CH3)3 (TMA) precursor and SF6 plasma as a co-reactant step. Details of the deposition process and conditions are described by (Vos et. al., 2021).

In a sixth step Al film was deposited on top of the underlying AIF3 film. The deposition was performed by PEALD using TMA as a precursor and H2 plasma as a co-reactant.

### Example 4:

A substrate comprises of a 3D patterned Si film is used as a support carrier for the layered stack.

In a second step, the three-dimensional substrate is conformally coated with an intermediate layer of SiO2. The SiO2 film is deposited by thermal atomic layer deposition with AP-LTO^{®}330 as Si precursor. The co-reactant half cycles are carried out with O3 as the oxygen source.

Deposition temperature was set to 300 °C. Film thickness of 10 nm of SiO2 is deposited by the thermal ALD process.

In a third step, a thin metallic film is deposited via atomic layer deposition. The metallic film is a catalyst layer of molybdenum carbide by means of plasma enhanced atomic layer deposition (PEALD). bis(tert-butylimido)-bis(dimethylamido)-molybdenum, Mo(tBuN)2(NMe2)2 (98%, Strem Chemicals), was employed as precursor. The precursor was bubbled by an argon flow of 50 sccm during the precursor dose step to the reaction chamber. During the plasma exposure step, a co-reactant H2/Ar is flowed to the reaction chamber, with a 4:1 ratio.

After the deposition of the catalyst layer, high quality graphene film was grown conformally on the catalyst layer. The catalyst film was saturated with carbon by annealing for 2 hours at 800 °C under low pressure of 4 mbar with CH4 as carbon feedstoock. Subsequently, graphene films were grown under similar conditions at 1100 °C for 10 minutes.

In a fourth step, the top graphene films are exposed to ultra fast laser. An ultrafast laser pulse with a photon energy of 1.55 eV is applied on the surface of the top graphene layer with a laser fluence of F = 0.905 mJ cm-2 for a period of 500 fs.

After the laser exposure, the top layer were deposited with Al2O3 films using plasma ALD process. The PEALD process uses Al(CH3)3 (TMA) precursor and O2 plasma as a co-reactant step. A layer of 10-40 nm Al2O3 film was deposited, preferably 10-20 nm.

In a fifth step, AIF3 was deposited by Plasma Enhanced ALD (PEALD), using Al(CH3)3 (TMA) precursor and SF6 plasma as a co-reactant step. Details of the deposition process and conditions are described by (Vos et. al., 2021).

In a sixth step Al film was deposited on top of the underlying AIF3 film. The deposition was performed by PEALD using TMA as a precursor and H2 plasma as a co-reactant.

In a seventh step, the AIF3 was conformally coated with a layer of MoOx. The MoOx film is deposited by plasma enhanced atomic layer deposition with bis(tert-butylimido)-bis(dimethylamido)-molybdenum, Mo(tBuN)2(NMe2)2 (98%, Strem Chemicals), as a Mo precursor. The plasma half cycle consisted of O2 gas for oxidation.

Deposition temperature is set to 200 °C. Film thickness of 20 nm of MoOx is deposited by the PEALD process.

### Example 5:

A substrate comprises of a thin SiN film is used as a support carrier for the layered stack.

In a first step, the three-dimensional substrate is conformally coated with an intermediate layer of SiO2. The SiO2 film is deposited by thermal atomic layer deposition with AP-LTO^{®}330 as Si precursor. The co-reactant half cycles are carried out with O3 as the oxygen source.

Deposition temperature was set to 300 °C. Film thickness of 10 nm of SiO2 is deposited by the thermal ALD process.

In a second step, a thin metallic film is deposited via atomic layer deposition on the substrate. The metallic film is a catalyst layer of molybdenum carbide by means of plasma enhanced atomic layer deposition (PEALD). bis(tert-butylimido)-bis(dimethylamido)-molybdenum, Mo(tBuN)2(NMe2)2 (98%, Strem Chemicals), was employed as precursor. The precursor was bubbled by an argon flow of 50 sccm during the precursor dose step to the reaction chamber. During the plasma exposure step, a co-reactant H2/Ar is flowed to the reaction chamber, with a 4:1 ratio.

After the deposition of the catalyst layer, high quality graphene film was grown conformally on the catalyst layer. The catalyst film was saturated with carbon by annealing for 2 hours at 800 °C under low pressure of 4 mbar with CH4 as carbon feedstoock. Subsequently, graphene films were grown under similar conditions at 1100 °C for 10 minutes.

In a third step, The top graphene films are exposed to hydrogen plasma for 30 seconds. After the plasma exposure, a thermal ALD process to deposit Al2O3 films was performed. A layer of 10-40 nm Al2O3 film was deposited, preferably 10-20 nm.

In a fourth step, AIF3 was deposited by Plasma Enhanced ALD (PEALD), using Al(CH3)3 (TMA) precursor and SF6 plasma as a co-reactant step. Details of the deposition process and conditions are described by (Vos et. al., 2021). The Al-fluoride film thickness is 10 nm.

In a fifth step Al film was deposited on top of the underlying AIF3 film. The deposition was performed by PEALD using TMA as a precursor and H2 plasma as a co-reactant. The Al film thickness is 100 nm.

### Example 6:

A substrate comprises of a thin SiN film is used as a support carrier for the layered stack.

In a first step, the three-dimensional substrate is conformally coated with an intermediate layer of SiO2. The SiO2 film is deposited by thermal atomic layer deposition with AP-LTO^{®}330 as Si precursor. The co-reactant half cycles are carried out with O3 as the oxygen source.

Deposition temperature was set to 300 °C. Film thickness of 10 nm of SiO2 is deposited by the thermal ALD process.

In a second step, a thin metallic film is deposited via atomic layer deposition on the substrate. The metallic film is a catalyst layer of molybdenum nitride by means of high temperature atomic layer deposition (HTALD). MoO2Cl2 was employed as precursor. The precursor dosed during the precursor half-cycle step to the reaction chamber. During the co-reactant half-cycle step, a co-reactant NH3 is flowed to the reaction chamber.

After the deposition of the catalyst layer, high quality graphene film was grown conformally on the catalyst layer. The catalyst film was saturated with carbon by annealing for 2 hours at 800 °C under low pressure of 4 mbar with CH4 as carbon feedstoock. Subsequently, graphene films were grown under similar conditions at 1100 °C for 10 minutes.

In a third step, the top graphene films are exposed to hydrogen plasma for 30 seconds. After the plasma exposure, a thermal ALD process to deposit Al2O3 films was performed. A layer of 10-40 nm Al2O3 film was deposited, preferably 10-20 nm.

In a fourth step, AIF3 was deposited by Plasma Enhanced ALD (PEALD), using Al(CH3)3 (TMA) precursor and SF6 plasma as a co-reactant step. Details of the deposition process and conditions are described by (Vos et. al., 2021). The Al-fluoride film thickness is 10 nm.

In a fifth step Al film was deposited on top of the underlying AIF3 film. The deposition was performed by PEALD using TMA as a precursor and H2 plasma as a co-reactant. The Al film thickness is 100 nm.

### Example 7:

A substrate comprises of a thin SiN film is used as a support carrier for the layered stack.

In a first step, the substrate is conformally coated with an intermediate layer of Al₂O₃. The Al₂O₃ film is deposited by plasma enhanced atomic layer deposition with TMA as Al₂O₃ precursor. The co-reactant half cycles are carried out with O₂ Plasma.

In a second step, a thin metallic film is deposited via atomic layer deposition on the substrate. The metallic film is a catalyst layer of molybdenum nitride by means of high temperature atomic layer deposition (HTALD). Deposition temperature was set to 450 °C. Film thickness of 10 nm of MoN is deposited by the thermal ALD process. MoO₂Cl₂ was employed as precursor. The precursor dosed during the precursor half-cycle step to the reaction chamber. During the co-reactant half-cycle step, a co-reactant NH₃ is flowed to the reaction chamber.

After the deposition of the catalyst layer, high quality graphene film was grown conformally on the catalyst layer. The catalyst film was saturated with carbon by annealing for 2 hours at 800 °C under low pressure of 4 mbar with CH4 as carbon feedstoock. Subsequently, graphene films were grown under similar conditions at 1100 °C for 10 minutes.

In a third step, the top graphene films are exposed to hydrogen plasma for 30 seconds. After the plasma exposure, a thermal ALD process to deposit Al₂O₃ films was performed. A layer of 10-40 nm Al₂O₃ film was deposited, preferably 10-20 nm.

In a fourth step, AlF₃ was deposited by Plasma Enhanced ALD (PEALD), using Al(CH₃)₃ (TMA) precursor and SF6 plasma as a co-reactant step. Details of the deposition process and conditions are described by (Vos et. al., 2021). The Al-fluoride film thickness is 10 nm.

In a fifth step Al film was deposited on top of the underlying AlF₃ film. The deposition was performed by PEALD using TMA as a precursor and H₂ plasma as a co-reactant. The Al film thickness is 100 nm.

### Example 8:

A substrate comprises of a thin SiN film is used as a support carrier for the layered stack.

In a first step, the substrate is conformally coated with an intermediate layer AF-4 Parylene.

The Parylene film is deposited by CVD process by vapour deposition of AF-4 Parylene dimeres.

The dimers are heated in a dedicated chamber at 650 °C, and the vapours are feed to the reaction chamber holding the substrate.

In a second step, the Parylene film is patterened to form 3D structures. The structuring of the Parylene film is performed by laser exposure at low power, 1 kHz frequency.

In a second step, a thin metallic film is deposited via atomic layer deposition on the Parylene substrate. The metallic film is a catalyst layer of molybdenum nitride by means of high temperature atomic layer deposition (HTALD). Deposition temperature was set to 450 °C. Film thickness of 10 nm of MoN is deposited by the thermal ALD process. MoO2Cl2 was employed as precursor. The precursor dosed during the precursor half-cycle step to the reaction chamber. During the co-reactant half-cycle step, a co-reactant NH3 is flowed to the reaction chamber.

After the deposition of the catalyst layer, high quality graphene film was grown conformally on the catalyst layer. The catalyst film was saturated with carbon by annealing for 2 hours at 800 °C under low pressure of 4 mbar with CH4 as carbon feedstoock. Subsequently, graphene films were grown under similar conditions at 1100 °C for 10 minutes.

In a third step, the top graphene films are exposed to hydrogen plasma for 30 seconds. After the plasma exposure, a thermal ALD process to deposit Al₂O₃ films was performed. A layer of 10-40 nm Al₂O₃ film was deposited, preferably 10-20 nm.

In a fourth step, AlF₃ was deposited by Plasma Enhanced ALD (PEALD), using Al(CH3)3 (TMA) precursor and SF6 plasma as a co-reactant step. Details of the deposition process and conditions are described by (Vos et. al., 2021). The Al-fluoride film thickness is 10 nm.

In a fifth step Al film was deposited on top of the underlying AlF₃ film. The deposition was performed by PEALD using TMA as a precursor and H₂ plasma as a co-reactant. The Al film thickness is 100 nm.

### Example 9:

A substrate comprises of a Si wafer is used as a support carrier for the layered stack.

In a first step, a 3D structure is printed on the substrate using a Original Prusa i3 MK3S+ 3D printer. The 3D printer fillament used is PLA.

In a second step, the 3D structure is patterned using a Oxford Lasers A-Series Laser dicer at low power with frequency of 1 kHz.

In a third step, the patterned 3D structure on the substrate is coated conformally by Parylene. The Parylene deposition is performed with a SCS Labcoater 2 Parylene Deposition System (PDS 2010).

The Parylene film is deposited by CVD process by vapour deposition of Parylene dimeres.

The dimers are heated in a dedicated chamber at 650 °C, and the vapours are feed to the reaction chamber holding the substrate.

In a fourth step, the deposited Parylene layer is removed from the underlying substrate. The removal is performed by soaking the substrate in a solvent the release the Parylene from the PLA layer. The solvent used is PGMA.

In a fifth step, the Parylene film is transferred onto a SiO₂ on Si substrate. After the transfer the substrate with the Parylene on top is thermally treated to improve adhesion.

In a sixth step, a thin metallic film is deposited via atomic layer deposition on the Parylene substrate. The metallic film is a catalyst layer of molybdenum nitride by means of high temperature atomic layer deposition (HTALD). Deposition temperature was set to 450 °C. Film thickness of 10 nm of MoN is deposited by the thermal ALD process. MoO₂Cl₂ was employed as precursor. The precursor dosed during the precursor half-cycle step to the reaction chamber. During the co-reactant half-cycle step, a co-reactant NH3 is flowed to the reaction chamber.

In a 7th step, after the deposition of the catalyst layer, high quality graphene film was grown conformally on the catalyst layer. The catalyst film was saturated with carbon by annealing for 2 hours at 800 °C under low pressure of 4 mbar with CH4 as carbon feedstoock. Subsequently, graphene films were grown under similar conditions at 1100 °C for 10 minutes.

In a 8th step, the top graphene films are exposed to hydrogen plasma for 30 seconds. After the plasma exposure, a thermal ALD process to deposit Al₂O₃ films was performed. A layer of 10-40 nm Al₂O₃ film was deposited, preferably 10-20 nm.

In a 9th step, AIF3 was deposited by Plasma Enhanced ALD (PEALD), using Al(CH3)3 (TMA) precursor and SF6 plasma as a co-reactant step. Details of the deposition process and conditions are described by (Vos et. al., 2021). The Al-fluoride film thickness is 10 nm.

In a 10th step Al film was deposited on top of the underlying AIF3 film. The deposition was performed by PEALD using TMA as a precursor and H₂ plasma as a co-reactant. The Al film thickness is 100 nm.

### Example 10:

In a first step, a photosensitive material (resist) is deposited on a SiO₂/Si substrate. The resist is patterned by photolithography and wet chemical removal of excess material.

In a second step, a thin metallic film is deposited via atomic layer deposition on the substrate. The metallic film is a catalyst layer of molybdenum carbide by means of plasma enhanced atomic layer deposition (PEALD). bis(tert-butylimido)-bis(dimethylamido)-molybdenum, Mo(tBuN)₂(NMe₂)₂ (98%, Strem Chemicals), was employed as precursor. The precursor was bubbled by an argon flow of 50 sccm during the precursor dose step to the reaction chamber. During the plasma exposure step, a co-reactant H₂/Ar is flowed to the reaction chamber, with a 4:1 ratio.

In a third step, the resist is removed by a lift-off process using IPA as a remover.

After the lift-off process, high quality graphene film was grown conformally on the catalyst layer. The catalyst film was saturated with carbon by annealing for 2 hours at 800 °C under low pressure of 4 mbar with CH4 as carbon feedstoock. Subsequently, graphene films were grown under similar conditions at 1100 °C for 10 minutes.

In a fourth step, the top graphene films are exposed to hydrogen plasma for 30 seconds. After the plasma exposure, a thermal ALD process to deposit Al₂O₃ films was performed. A layer of 10-40 nm Al₂O₃ film was deposited, preferably 10-20 nm.

In a fourth step, AIF3 was deposited by Plasma Enhanced ALD (PEALD), using Al(CH₃)₃ (TMA) precursor and SF6 plasma as a co-reactant step. Details of the deposition process and conditions are described by (Vos et. al., 2021). The Al-fluoride film thickness is 10 nm.

In a fifth step, a Plasma Enhanced ALD process to deposit Al₂O₃ films was performed. A layer of 10-40 nm Al₂O₃ film was deposited, preferably 10-20 nm. In the precursor half cycle TMA is used, and in the co-reactant half cycle O₂ plasma is used, with Ar purge steps between each half cycle.

In a sixth step, photosensitive material (resist) is deposited conformally on the Al₂O₃ layer. The resist is patterned by photolithography and wet chemical removal of excess material.

In a seventh step, gold is evaporated on top of the exposed Al₂O₃ layer. After the deposition of gold contacts, the residual resist is removed by soaking in IPA solution.

In an 8th step, Aluminum contact tabs are welded to the gold contacts by ultrasonic welding.

The substrate stack is then sealed in vacuum conditions, so that only the Al-contact tabs are exposed on their external side.

### Example 11:

In a first step, a h-BN is deposited on a SiO₂/Si substrate. The h-BN is deposited by Plasma enhanced atomic layer deposition using N₂/NH₃ gas as co-reactant, and Tris(ethylmethylamino) borane (TEMAB, C₉H₂₄BN₃) as a precursor. The deposition parameters are performed as described by {Park et. al., 2017}. The h-BN film thickness is between 5-20 nm, preferably 5-10 nm.

In a second step, a thin metallic film is deposited via atomic layer deposition on a h-BN/SiO₂/Si substrate. The metallic film is a catalyst layer of molybdenum carbide by means of plasma enhanced atomic layer deposition (PEALD). bis(tert-butylimido)-bis(dimethylamido)-molybdenum, Mo(tBuN)₂(NMe₂)2 (98%, Strem Chemicals), was employed as precursor. The precursor was bubbled by an argon flow of 50 sccm during the precursor dose step to the reaction chamber. During the plasma exposure step, a co-reactant H₂/Ar is flowed to the reaction chamber, with a 4:1 ratio.

In a third step, high quality graphene film was grown conformally on the catalyst layer. The catalyst film was saturated with carbon by annealing for 2 hours at 800 °C under low pressure of 4 mbar with CH4 as carbon feedstoock. Subsequently, graphene films were grown under similar conditions at 1100 °C for 10 minutes.

In a fourth step, a the top graphene films are exposed to hydrogen plasma for 30 seconds. After the plasma exposure, a thermal ALD process to deposit Al₂O₃ films was performed. A layer of 5-40 nm Al₂O₃ film was deposited, preferably 5-10 nm.

In a fifth step, a photosensitive material (resist) is deposited conformally on the Al₂O₃ layer. The resist is patterned by photolithography and wet chemical removal of excess material.

In a seventh step, gold is evaporated on top of the exposed Al₂O₃ layer. After the deposition of gold contacts, the residual resist is removed by soaking in IPA solution.

### Example 12:

In a first step, a h-BN is deposited on a SiO₂/Si substrate. The h-BN is deposited by Plasma enhanced atomic layer deposition using N₂/NH₃ gas as co-reactant, and Tris(ethylmethylamino) borane (TEMAB, C₉H₂₄BN₃) as a precursor. The deposition parameters are performed as described by {Park et. al., 2017}. The h-BN film thickness is between 5-20 nm, preferably 5-10 nm.

In a second step, a graphene layer or layers were deposited via atomic layer deposition on a h-BN/SiO₂/Si substrate. A thin metallic film is deposited via atomic layer deposition on a h-BN/SiO₂/Si substrate. The metallic film is a catalyst layer of molybdenum carbide by means of plasma enhanced atomic layer deposition (PEALD). Bis(tert-butylimido)-bis(dimethylamido)-molybdenum, Mo(tBuN)₂(NMe₂)2 (98%, Strem Chemicals), was employed as precursor. The precursor was bubbled by an argon flow of 50 sccm during the precursor dose step to the reaction chamber. During the plasma exposure step, a co-reactant H₂/Ar is flowed to the reaction chamber, with a 4:1 ratio. A super-cycle ALD step using an organic molecule as a precursor was employed. The organic precursor is 1,4-benzene dithiol (BDT) (99%, Sigma-Aldrich). During the plasma exposure step, a co-reactant H₂ is flowed to the reaction chamber.

In a third step, a the top graphene films are exposed to hydrogen plasma for 30 seconds. After the plasma exposure, a thermal ALD process to deposit Al₂O₃ films was performed. A layer of 5-40 nm Al₂O₃ film was deposited, preferably 5-10 nm.

In a fourth step, a photosensitive material (resist) is deposited conformally on the Al₂O₃ layer. The resist is patterned by photolithography and wet chemical removal of excess material.

In a fifth step, gold is evaporated on top of the exposed Al₂O₃ layer. After the deposition of gold contacts, the residual resist is removed by soaking in IPA solution.

### Example 13:

In a first step, a h-BN is deposited on a SiO₂/Si substrate. The h-BN is deposited by Plasma enhanced atomic layer deposition using N₂/NH₃ gas as co-reactant, and Tris(ethylmethylamino) borane (TEMAB, C₉H2₄BN₃) as a precursor. The deposition parameters are performed as described by {Park et. al., 2017}. The h-BN film thickness is between 5-20 nm, preferably 5-10 nm.

In a second step, a graphene layer or layers were deposited via atomic layer deposition on a h-BN/SiO₂/Si substrate. Initially, a thin carbon catalyst film was deposited by means of plasma enhanced atomic layer deposition (PEALD). Carbon tetrabromide (CBr₄) (99%, Sigma-Aldrich), was employed as a precursor. The precursor was bubbled by an argon flow of 50 sccm during the precursor dose step to the reaction chamber. During the plasma exposure step, a co-reactant H₂/Ar is flowed to the reaction chamber, with a 4:1 ratio.

In a third step, a the top graphene films are exposed to hydrogen plasma for 30 seconds. After the plasma exposure, a thermal ALD process to deposit Al₂O₃ films was performed. A layer of 5-40 nm Al₂O₃ film was deposited, preferably 5-10 nm.

In a fourth step, a photosensitive material (resist) is deposited conformally on the Al₂O₃ layer. The resist is patterned by photolithography and wet chemical removal of excess material.

In a fifth step, gold is evaporated on top of the exposed Al₂O₃ layer. After the deposition of gold contacts, the residual resist is removed by soaking in IPA solution.

## Claims

1. A stacked composite structure comprising
(i) a substrate/support layer having a three-dimensional surface topology, wherein said three-dimensional topology comprises a plurality of protruding structures and a plurality of cavities between two or more protruding structures;
(ii) a graphene layer, or a plurality of graphene layers being, directly or with an interjacent catalyst layer, conformally grown on at least a part of said substrate/support layer;
(iii) a metal-oxide layer conformally coated on at least a part of said graphene layer(s);
(iv) a solid-state electrolyte layer conformally coated on at least a part of said metal-oxide layer; and
(v) a metal and/or metal-oxide layer conformally coated on at least a part of said solid-state electrolyte layer;
or a composite structure with repeating stackings of said layers (i) to (v), wherein said layers (i) to (v) in said repeating stackings may be same or different.

2. The stacked composite structure according to claim 1, wherein the plurality of protruding structures are selected from nanotubes, nanopillars, nanowires, fibers and/or cellulose, preferably the ratio between a surface area of the protruding structures and corresponding cavities and a base area on the substrate covered by said protruding structures and cavities is in the range of from 5 to 100,000, preferably 100 to 100,000.

3. The stacked composite structure according to claim 1 or 2, wherein the substrate having a three-dimensional topology covers at least part of the substrate.

4. The stacked composite structure according to one or more of claims 1 to 3, wherein
(i) the stacked composite structure comprises an intermittent catalyst layer between said substrate/support layer and said graphene layer, wherein said catalyst layer preferably comprises elementary or compound transition metals or metals deposited in a conformal way, and/or has thickness of 0.3 to 10 nm, most preferably the catalyst layer comprises carbides and/or nitrides of Mo, W, Ta, Ti, Nb, Zr, Va, La, Y, Cr, Hf, Ni, Cu or Pt; and/or
(ii) said graphene layer(s) on said substrate/support layer or said intermittent catalyst layer being obtained by conformally growing the graphene layer(s) thereon by radiative or thermal treatment with a carbon feedstock, preferably the graphene layer(s), independent from each other, having a thickness of 0.3 to 10 nm each; and/or
(iii) said metal oxide layer comprises oxides of Al, Mo, W, Ta, Ti, Nb, Zr, V, La, Y, Cr, Hf, Ni, Cu or Pt, or a mixture thereof, and/or has thickness of 1 to 50 nm, preferably the metal oxide layer is obtained by thin film deposition techniques on said graphene layer(s).

5. The stacked composite structure according to any one of the preceding claims, wherein
(i) said solid-state electrolyte layer comprises a fluoride of Al, Mo, W, Ta, Ti, Nb, Zr, V, La, Y, Cr, or Hf, or NaCl, KCl, salts of Al₂Cl₇⁻ and AlCl₄⁻, LLZTO, LiPF₆ , LiPON, LiF, (MeO)₃PO, Ta(OEt)₅, Nb(OEt)₅, Si(OC₂H₅)₄, H₂NP(O)(OC₂H₅)₂, P(NMe₂)₃, Al₂(NMe₂)₆, LaFAMD, Zr(NMe₂)₄, TiF₄, [(CH₃)₂CHO]₃B, beta-alumina or a combination thereof, more preferably the solid-state electrolyte layer is a metal-fluoride layer, most preferably the metal-fluoride layer is composed of TiF₄, LiF, AlF₃, or any conceivable variation thereof, preferably said the solid-state electrolyte layer being conformally coated onto the metal-oxide layer by plasma enhanced atomic layer deposition, and/or having a thickness of 1 to 50 nm; and/or
(ii) said metallic layer metal and/or metal-oxide layer comprises an elementary or compound metals of Al, Mo, W, Ta, Ti, Nb, Zr, V, La, Y, Cr, Hf, Ni, Cu, Ag, Au, Pd or Pt, or an oxide, nitride, or carbide thereof. or mixtures thereof, compound, or a metal element, and/or has thickness of 1 to 20 nm, preferably the metal oxide layer is obtained by thin film deposition techniques on said solid-state electrolyte layer; and/or
(iii) the order of the layers in each composite structure is (i) to (v).

6. A three-dimensional graphene energy storage device, or an electrode comprising a stacked composite structure according to any one of claims 1 to 5.

7. The three-dimensional graphene energy storage device according to claim 6, which is an aluminum-graphene battery, a supercapacitor or a proton exchange membrane, preferably the three-dimensional graphene energy storage device is an aluminum-graphene battery or a supercapacitor and is contained in a sealed structure, such as a pouch cell, more preferably the aluminum-battery power density is higher than 1 kW, preferably 5 kW, most preferably 10 kW, and the supercapacitor's energy density is higher than that of batteries, even more preferably is higher than 1000 Wh/kg, most preferably is higher than 2000 Wh/kg.

8. A process for the preparation of a stacked composite structure or for the preparation of the stacked composite structure according to any one of claims 1 to 5, said processes comprising the steps of:
a) providing a substrate/support layer having a three-dimensional surface topology, wherein
said three-dimensional topology comprises a plurality of protruding structures and a plurality of cavities between two or more protruding structures;
b) coating at least a portion of the substrate conformally with a catalyst layer;
c) conformally growing one or a plurality of graphene layer(s) on at least a portion of the catalyst, wherein the graphene film comprises one or more graphene layers;
d) conformally coating at least part of the graphene film with metal-oxide layer;
e) conformally coating at least part of the metal-oxide layer with a solid-state electrolyte layer;
f) conformally coating at least part of the solid-state electrolyte layer with a metal and/or metal-oxide layer; and optionally
g) repeated stacking of a stack of said layers according to claims a) to f) on top of the previous stack.

9. A process for the preparation of three-dimensional graphene energy storage device, or for the preparation of three-dimensional graphene energy storage device according to claim 6 or 7, said processes comprising the steps of:
a) providing a substrate/support layer having a three-dimensional surface topology, wherein said three-dimensional topology comprises a plurality of protruding structures and a plurality of cavities between two or more protruding structures;
b) coating at least a portion of the substrate conformally with a catalyst layer;
c) conformally growing one or a plurality of graphene layer(s) on at least a portion of the catalyst, wherein the graphene film comprises one or more graphene layers;
d) conformally coating at least part of the graphene film with metal-oxide layer;
e) conformally coating at least part of the metal-oxide layer with a solid-state electrolyte layer;
f) conformally coating at least part of the solid-state electrolyte layer with a metal and/or metal-oxide layer; and optionally
g) repeated stacking of a stack of said layers according to claims a) to f) on top of the previous stack; and
h) sealing the stacks, especially under vacuum conditions, preferably in a pouch cell.

10. The process according to claim 8 or 9, wherein conformally coating of the substrate with a catalyst layer comprises thin film deposition techniques, preferably said thin film deposition techniques comprise atomic layer deposition (ALD), especially plasma enhanced atomic layer deposition (PEALD), especially high-temperature ALD (HTALD), physical vapor deposition (PVD) or chemical vapor deposition (CVD), more preferably
(i) coating of the substrate comprises plasma enhanced atomic layer deposition comprising at least one precursor dose step, a first purge step, a plasma exposure step and a second purge step, wherein the catalyst layer comprises a carbon-based organic film or a carbide of Mo, W, Ta, Ti, Nb, Zr, V, La, Y, Cr, Hf, Ni, Cu or Pt, or a mixture thereof; or
(ii) coating of the substrate comprises high temperature atomic layer deposition comprising at least one precursor dose step, a first purge step, a co-reactant gas step and a second purge step, wherein the catalyst layer comprises a carbide of Mo, W, Ta, Ti, Nb, Zr, V, La, Y, Cr, Hf, Ni, Cu or Pt, or a mixture thereof; or
(iii) coating of the substrate comprises plasma enhanced atomic layer deposition comprising at least one precursor dose step, a first purge step, a plasma exposure step and a second purge step, wherein the catalyst layer comprises a benzene compound or generally compounds comprising methine groups, most preferably, without limitation, methane, ethanol, ethane, ethene, ethyne, propane, propene, propadiene, propyne, butane, butene, butadiene, butariene, and/or butyne.

11. The process according to one or more of claims 8 to 10, wherein
(i) conformally growing a graphene film on the catalyst coating comprises plasma treatment at temperature lower than 600 °C. Preferably, lower than 500 °C, especially lower than 400 °C; or
(ii) conformally growing one or a plurality of graphene layer(s) on the catalyst coating comprises thermal treatment at a temperature between 600 and 850 °C with a carbon feedstock and subsequently growing graphene layer(s) by a second thermal treatment at a temperature between 800 and 1300 °C; or
(iii) conformally coating comprises coating of the graphene film with a thin film, wherein the film preferably is an insulator, and/or with a metal-compound layer which comprises thin film deposition techniques, most preferably coating of the substrate comprises plasma enhanced atomic layer deposition comprising at least one precursor dose step, a first purge step, a plasma exposure step and a second purge step, wherein the insulator comprises h-BN and/or the metal-compound layer comprises of Al, Mo, W, Ta, Ti, Nb, Zr, V, La, Yt, Cr, Hf, Ni, Cu or P and their oxides, nitrides, and/or dihalogenides; or
(iv) conformally coating of the graphene layer(s)with a metal-oxide layer comprises thin film deposition techniques, preferably coating of the graphene layers(s) comprises plasma enhanced atomic layer deposition comprising at least one precursor dose step, a first purge step, a plasma exposure step and a second purge step, wherein the metal-oxide layer comprises oxides of Al, Mo, W, Ta, Ti, Nb, Zr, V, La, Y, Cr, Hf, Ni, Cu or Pt, or a mixture thereof; or
(v) conformally coating of the metal-oxide layer with the solid-state electrolyte layer comprises thin film deposition techniques; preferably said thin film deposition techniques comprise atomic layer deposition (ALD), especially plasma enhanced atomic layer deposition (PEALD), physical vapor deposition (PVD) or chemical vapor deposition (CVD), most preferably the conformally coating of the metal-oxide layer with the solid-state electrolyte layer comprises plasma enhanced atomic layer deposition comprising at least one precursor dose step, a first purge step, a plasma exposure step and a second purge step, wherein the solid-state electrolyte layer conformally coated to the metal-oxide layer, preferably the solid-state electrolyte layer comprises a fluoride of Al, Mo, W, Ta, Ti, Nb, Zr, V, La, Y, Cr or Hf, NaCl, KCl, salts of Al₂Cl₇⁻ and AlCl₄⁻, LLZTO, LiPF₆ , LiPON, LiF, (MeO)₃PO, Ta(OEt)₅, Nb(OEt)₅, Si(OC₂H₅)₄, H₂NP(O)(OC₂H₅)₂, P(NMe₂)₃, Al₂(NMe₂)₆, LaFAMD, Zr(NMe₂)₄, TiF₄, [(CH₃)₂CHO]₃B, beta-alumina or a combination thereof, more preferably the solid-state electrolyte layer is a metal-fluoride layer, most preferably the metal-fluoride layer is composed of TiF₄, LiF, AlF₃, or any conceivable variation thereof; or
(vi) conformally coating at least a portion of the solid-state electrolyte layer with a metal and/or metal-oxide layer comprises thin film deposition techniques, preferably said thin film deposition techniques comprise atomic layer deposition (ALD), especially plasma enhanced atomic layer deposition (PEALD), physical vapor deposition (PVD) or chemical vapor deposition (CVD), most preferably coating of the substrate comprises plasma enhanced atomic layer deposition comprising at least one precursor dose step, a first purge step, a plasma exposure step and a second purge step, wherein the metallic layer preferably comprises an elementary or compound metals of Al, Mo, W, Ta, Ti, Nb, Zr, V, La, Y, Cr, Hf, Ni, Cu, Ag, Au, Pd or Pt deposited in a conformal way.

12. A three-dimensional homogenous graphene film obtainable by the process according to one or more of claims 8 to 11, or an electrode comprising the three-dimensional homogenous graphene film obtainable by the process according to one or more of claims 8 to 11 conformally on the three-dimensional substrate, preferably the electrode is an anode or cathode and further comprises an anode metallic layer and/or a cathode metallic layer, respectively.

13. An energy storage device comprising an anode and a cathode according to claim 12 and a solid-state electrolyte corresponding to the electrolyte of the solid-state electrolyte layer of the stacked composite structure, preferably in said energy storage device the solid-state electrolyte is as defined in claim 11, and/or the energy storage device is comprised in a pouch cell and optionally said pouch cell being sealed.

14. Stackings of energy storage devices according to any one of claims 7-8 and 13, or a graphene-field-effect-transistor according to claims 12-13.

15. Use of the three-dimensional graphene-metal composite device, according to claim 13 or 14,
in an aluminum-graphene battery, in a supercapacitor, in a proton exchange membrane, in a quantum dot device, in a neuromorphic memristive synapse, in graphene-field effect transistor or as an interconnect.
